# EUROPÄISCHE PATENTSCHRIFT

(11) **EP 1 547 124 B1**
(45) Veröffentlichungstag und Bekanntmachung des Hinweises auf die Patenterteilung: **24.05.2006**
(21) Anmeldenummer: 03798846.6
(22) Anmeldetag: 09.09.2003
(51) Int. Cl.: H01J 37/32, C23C 14/56, H01J 37/34

(54) **VORRICHTUNG ZUR BEHANDLUNG EINES BANDFÖRMIGEN MATERIALS IN EINEM PLASMA-UNTERSTÜTZTEN PROZESS**
DEVICE FOR THE TREATMENT OF A WEB-TYPE MATERIAL IN A PLASMA-ASSISTED PROCESS
DISPOSITIF POUR TRAITER UNE MATIERE SOUS FORME DE BANDE DANS UN PROCESSUS RENFORCE EN PLASMA

(30) Priorität: 03.10.2002 CH 16522002
(43) Veröffentlichungstag der Anmeldung: 29.06.2005
(73) Patentinhaber: Tetra Laval Holdings & Finance S.A., 1009 Pully (CH)
(72) Erfinder: FAYET, Pierre, CH-1006 Lausanne (CH); JACCOUD, Bertrand, CH-1678 Siviriez (CH)
(74) Vertreter: Frei Patent Attorneys
(86) Internationale Anmeldenummer: PCT/CH2003/000609
(87) Internationale Veröffentlichungsnummer: WO 2004/032175

(56) Entgegenhaltungen:
- DE-A- 3 735 162
- US-A- 4 322 276
- US-A- 5 224 441
- PATENT ABSTRACTS OF JAPAN vol. 1999, no. 09, 30. Juli 1999 (1999-07-30) & JP 11 092579 A (NITTO DENKO CORP), 6. April 1999 (1999-04-06)
- PATENT ABSTRACTS OF JAPAN vol. 012, no. 358 (C-531), 26. September 1988 (1988-09-26) & JP 63 112441 A (NIPPON SHEET GLASS CO LTD), 17. Mai 1988 (1988-05-17)

## Beschreibung

Die Erfindung betrifft eine Vorrichtung nach dem Oberbegriff des ersten, unabhängigen Patentanspruchs. Die Vorrichtung dient zur Behandlung einer Oberfläche eines bandförmigen Materials in einem Plasma-unterstützten Prozess, insbesondere zur Beschichtung eines flexiblen, bandförmigen Materials mittels Plasma-unterstützter, chemischer Abscheidung aus der Gasphase, beispielsweise zur Beschichtung eines bandförmigen Kunststofffilmes mit Siliziumoxyd zur Verbesserung der Barriereeigenschaften des Filmmaterials.

Eine Vorrichtung zum Behandlung eines bandförmigen Materials in einem Plasma-unterstützter Prozess ist beschrieben beispielsweise in der Publikation, EP-0605534 (oder US-5224441, BOC). Die Vorrichtung weist eine unter Spannung stehende Elektrode auf, die die Form einer rotierenden Trommel hat, und einen geerdeten Schild, der die Form eines etwa halben hohlen Zylinders aufweist und derart angeordnet ist, dass er zusammen mit der Trommel einen Zwischenraum bildet, der eine Breite von 1 bis 30 cm aufweist. Auf derjenigen Seite des Schilds, die von der Trommel weggewandt ist, ist eine Mehrzahl von Permanentmagneten angeordnet, derart, dass Pole alternierender Polarität gegen die Trommel gerichtet sind. Für die Zuführung eines Prozessgases oder einer Prozessgasmischung in die Zwischenraum zwischen Trommel und Schild weist die Vorrichtung eine Gaszuführungsleitung auf, die sich in der Mitte des Schilds parallel zur Trommelachse erstreckt. Die Trommel, der Schild mit den Magneten und die Gaszuführungsleitung sind in einer Vakuumkammer angeordnet, wobei die Vakuumkammer ferner Mittel zur Wegführung von Prozessgas aus der Kammer und zur Aufrechterhaltung eines konstanten, reduzierten Druckes in der Kammer aufweist.

Das bandförmige, flexible Material wird durch den Zwischenraum zwischen Trommel und Schild gefördert, dadurch, dass es von der Trommel gestützt und transportiert wird, das heisst auf einem Teil der Umfangfläche der Trommel aufliegt. Das Plasma wird in diesem Zwischenraum aufrechterhalten durch elektrische Energie, die der Trommel in Form einer hochfrequenten Wechselspannung zugeführt wird und durch Zuführung einer Prozessgasmischung zum Plasma. Der in der genannten Publikation beschriebene Plasma-unterstützte Prozess ist eine chemische Abscheidung von Siliziumoxyd aus der Gasphase auf einen Kunststofffilm, wozu eine Prozessgasmischung aus einer Organosilizium-Verbindung, Sauerstoff und einem inerten Gas verwendet wird.

Eine weitere Vorrichtung für die Behandlung eines bandförmigen, flexiblen Materials in einem Plasma-unterstützten Prozess ist beschrieben in der Publikation US-4968918 (Kondo et al.). Die Vorrichtung weist eine Mehrzahl von stationären Antennenelektroden auf, die radial von einem zentralen Energiezuführungsmittel angeordnet in einer im wesentlichen zylindrischen Vakuumkammer angeordnet sind. Zwischen je zwei benachbarten Antennenelektroden ist je eine geerdete Gegenelektrode angeordnet. Gaszuführungsleitungen erstrecken sich axial, beispielsweise entlang des äusseren Randes der geerdeten Elektroden. Das bandförmige, flexible Material wird in einer Art Zick-Zack-Weg zwischen den Antennenelektroden und den geerdeten Elektroden hindurchgeführt, wobei es entweder an den Antennenelektroden oder an den Gegenelektroden anliegt. Der Prozess, der mit Hilfe der Vorrichtung durchgeführt wird, ist eine Ätzung, für die Sauerstoff als Prozessgas eingesetzt wird, eine Plasmapolymerisation, eine chemische Abscheidung aus der Gasphase oder ein ähnlicher Prozess.

Eine Vorrichtung nach dem Oberbegriff des ersten Anspruchs ist in JP-11092579 und DE-3735162 offenbart.

Es ist die Aufgabe der Erfindung, eine Vorrichtung zur Behandlung eines bandförmigen Materials mit Hilfe eines Plasma-unterstützten Prozesses zu schaffen, wobei die Vorrichtung einen effizienteren und zuverlässigeren Betrieb erlauben soll als bekannte Vorrichtungen zur Durchführung gleicher Prozesse. Zusätzlich soll die Vorrichtung konstruktiv einfach sein und sie soll einen einfachen Betrieb und einfachen Unterhalt erlauben.

Diese Aufgabe wird gelöst durch die Vorrichtung, wie sie in der Patentansprüchen definiert ist.

Die erfindungsmäßige Vorrichtung ist in Anspruch 1 definiert.

Die erfindungsgemässe Vorrichtung weist beispielsweise innerhalb einer Vakuumkammer eine rotierende Trommel (oder äquivalentes Mittel) auf, die für die Stützung und den Transport des auf einem Teil ihrer Umfangfläche aufliegenden, bandförmigen Materials ausgerüstet ist und für die Funktion einer von zwei Elektroden, zwischen denen das Plasma erzeugt werden soll. Weiter weist die Vorrichtung in der Vakuumkammer eine Mehrzahl von weiteren Elektroden auf, die für eine Magnetron-Funktion ausgerüstet sind, das heisst Elektroden, die Mittel zur Erzeugung eines alternierenden elektrischen Feldes, das sich für die Aufrechterhaltung eines Plasmas eignet, aufweisen sowie Mittel zur Erzeugung eines magnetischen Feldes, das geeignet ist, elektrisch geladene Partikel, insbesondere Elektronen, mindestens teilweise im Plasma gefangen zu halten. Die Magnetron-Elektroden sind derart angeordnet, dass sie zusammen mit der Trommel einen Zwischenraum bilden, der sich über einen Teil der Umfangsfläche der Trommel erstreckt und durch den das bandförmige Material auf der Trommeloberfläche aufliegend transportiert wird.

Die Magnetron-Elektroden haben rechteckige Magnetron-Fronten, die gegen die Trommel gerichtet sind und die von der Umfangsfläche der Trommel beabstandet sind, wobei ihre Länge parallel zur Trommelachse und ihre Breite im wesentlichen tangential zur Trommel ausgerichtet ist. Die Magnetron-Elektroden sind nebeneinander angeordnet und bilden zusammen mit der Umfangsfläche der Trommel den oben genannten Zwischenraum, der im wesentlichen die Form eines Teils eines Hohlzylinders aufweist. Jede der Magnetron-Elektroden ist an eine eigene Spannungsquelle angeschlossen. Die Trommel-Elektrode ist elektrisch geerdet, ist nicht an eine definierte Referenzspannung angeschlossen (floating) oder ist an eine negative Vorspannung angeschlossen.

Gaszuführungsleitungen erstrecken sich parallel zur Trommelachse entweder zwischen benachbarten Magnetron-Fronten oder in den Magnetron-Fronten. Die Vakuumkammer weist femer Mittel zum Absaugen von Gas aus der Kammer und zur Aufrechterhaltung eines konstanten, reduzierten Druckes in der Kammer auf.

Es ist keine Bedingung für die erfindungsgemässe Vorrichtung, dass das bandförmige Material von einer rotierenden Trommel gestützt und transportiert wird. Die Funktion der Trommel (Stützung und Transport des bandförmigen Materials und Gegenelektrode zu den Magnetron-Elektroden) kann auch übernommen werden beispielsweise durch einen umlaufenden Riemen, dem in diesem Fall eine gerade Reihe von Magnetron-Fronten gegenübersteht.

Experimente zeigen, dass Plasma-unterstützte, chemische Abscheidung aus der Gasphase auf einem bandförmigen Material effizienter und zuverlässiger ist bei Verwendung der erfindungsgemässen Vorrichtung als bei Verwendung einer bekannten Vorrichtung. Die Beschichtung, die mit der erfindungsgemässen Vorrichtung erzeugt wird, weist auch weniger Qalitätsschwankungen auf. Dies ist offenbar darauf zurückzuführen, dass das Plasma, das mit Hilfe der voneinander unabhängigen und nahe beieinander angeordneten Magnetron-Elektroden erzeugt wird, einen homogeneren Charakter aufweist als ähnliches Plasma, das zwischen nur zwei, entsprechend grösserflächigen Elektroden erzeugt wird. Beispielsweise in der Vorrichtung gemäss der oben bereits erwähnten Publikation EP-0605534 ist klar sichtbar, dass die Plasma-Intensität vom Bereich, in dem das bandförmige Material in den Plasmaraum eintritt, zum Bereich, wo es austritt, zunimmt. Entsprechende Experimente zeigen, dass beim Durchgang des bandförmigen Materials durch dieses Plasma mit dem starken Intensitätsgradienten 10% der Beschichtung im ersten Drittel des Weges abgeschieden wird, 20% im mittleren Drittel und 70% im letzten Drittel, der am Ausgang endet. Im Gegensatz dazu hat das Plasma, das mit einer Mehrzahl von individuell gespeisten Magnetron-Elektroden erzeugt wird, entlang des ganzen Weges des bandförmigen Materials eine gleichbleibende Intensität und die Abscheidungsgeschwindigkeit bleibt im wesentlichen gleich entlang des ganzen Weges.

Experimente zeigen auch, dass eine Plasma-unterstützte, chemische Abscheidung aus der Gasphase unter Verwendung der erfindungsgemässen Vorrichtung mit einer Mehrzahl von individuell gespeisten Magnetron-Elektroden, die gegen die zu beschichtende Oberfläche gewandt sind, bedeutend weniger Beschichtung der Magnetron-Elektroden bringt als dies auf dem geerdeten Schild der Vorrichtung gemäss EP-0605534 der Fall ist. Dies bedeutet nicht nur höhere Effizient der Abscheidung auf dem bandförmigen Material sondern bedeutet auch, dass die erfindungsgemässe Vorrichtung weniger Unterhalt in Form von Elektrodenreinigung braucht, das heisst länger unterbuchslos in Betrieb sein kann und/oder weniger Unterhaltszeit benötigt. Dazu kommt, dass Reinigung und Unterhalt sehr einfach sind, wenn jede der Magnetron-Elektroden, die einzeln ein geringes Gewicht haben, auf axial verlaufenden Schienen schiebbar montiert sind, derart, dass sie einfach von ihrer Stellung gegenüber der Trommel extrahiert und wieder positioniert werden können.

Es ist auch möglich, die erfindungsgemässe Vorrichtung mit gleichem Resultat bezüglich Qualität zu betreiben, wenn eine oder sogar mehr als eine der Magnetron-Elektroden ausser Betrieb ist, wenn zur Erreichung der gleichen Behandlungszeit die Drehgeschwindigkeit der Trommel entsprechend reduziert wird.

Beispielhafte Ausführungsformen der erfindungsgemässen Vorrichtung werden im Zusammenhang mit den folgenden Figuren beschrieben. Dabei zeigen:
- **Figur 1**: einen schematischen Schnitt senkrecht zur Trommelachse durch eine beispielhafte Ausführungsform der erfindungsgemässen Vorrichtung;
- **Figuren 2 und 3**: zwei beispielhafte Ausführungsformen der Anordnung von Magnetron-Elektroden in der erfindungsgemässen Vorrichtung;
- **Figuren 4 und 5**: die Front und einen Schnitt senkrecht zur Front einer beispielhaften Ausführungsform einer in der erfindungsgemässen Vorrichtung anwendbaren Magnetron-Elektrode;
- **Figuren 6 und 7**: Fronten von zwei weiteren, beispielhaften Ausführungsformen von in der erfindungsgemässen Vorrichtung anwendbaren Magnetron-Elektroden.

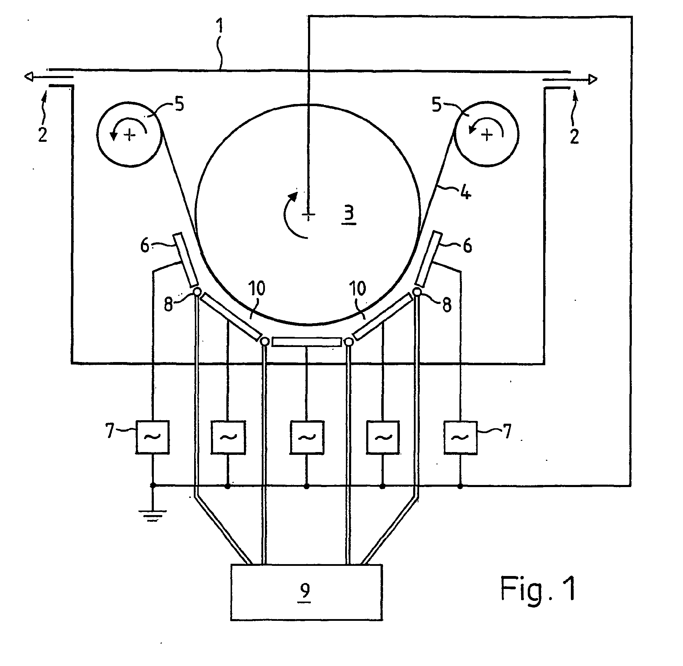

**Figur 1** zeigt in einer sehr schematischen Art die wesentlichen Bestandteile der erfindungsgemässen Vorrichtung. Diese wesentlichen Bestandteile sind: eine Vakuumkammer 1 mit Mitteln 2 zur Absaugung von Gas aus der Kammer und zur Aufrechterhaltung eines konstanten, reduzierten Druckes in der Kammer 1; eine in der Vakuumkammer angeordnete, rotierende Trommel 3, die der Stützung und dem Transport des bandförmigen, zu behandelnden Materials 4 dient; zwei Rollen 5 für die Lieferung des zu behandelnden Materials und für den Empfang des behandelten Materials 4, wobei die Rollen vorteilhafterweise ebenfalls in der Vakuumkammer angeordnet sind; eine Mehrzahl von Magnetron-Elektroden 6, die gegen die Umfangsfläche der Trommel 3 gerichtet sind und von denen jede an einer eigenen Spannungsquelle 7 angeschlossen ist (an Phase der Spannungsquelle angeschlossen); und Gaszuführungsleitungen 8, die im wesentlichen parallel zur Trommelachse ausgerichtet und beispielsweise an einem das Prozessgas oder die Prozessgasmischung liefernden, gemeinsamen Gasliefermittel 9 angeschlossen sind.

Das Plasma ist im Raum 10 zwischen den Fronten der Magnetron-Elektroden 6 und der Umfangsfläche der Trommel 3 eingeschlossen.

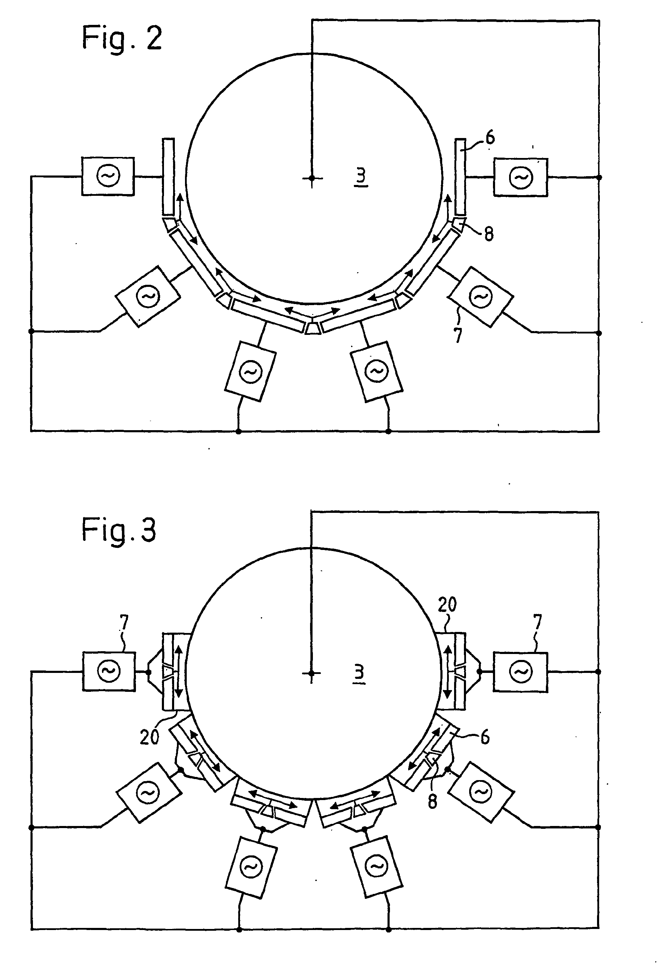

**Figuren 2 und 3** zeigen zwei beispielhafte Anordnungen von Magnetron-Elektroden in der erfindungsgemässen Vorrichtung. Die Magnetron-Elektroden sind um einen Teil der Umfangsfläche der Trommel angeordnet und jede ist gespeist durch eine eigene Spannungsquelle 7. Die Magnetron-Fronten sind rechteckig, wobei ihre Länge in Richtung der Trommelachse und ihre Breiten im wesentlichen tangential an die Trommel ausgerichtet sind. Die Breite jeder Magnetron-Front ist beispielsweise 15 cm; ihre Länge entspricht mindestens der Breite des zu behandelnden, bandförmigen Materials.

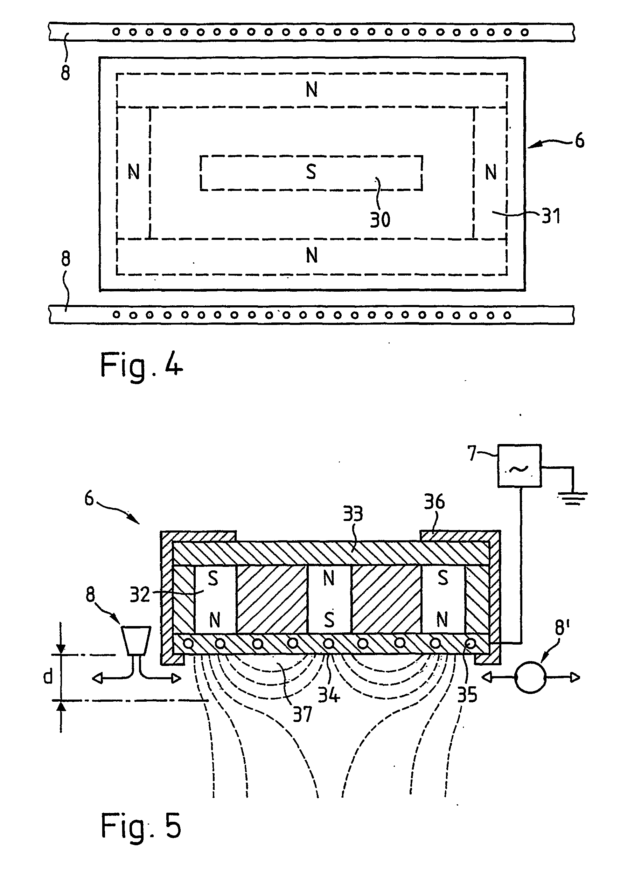

Gemäss Figur 2 sind die Gaszuführungsleitungen (z.B. Gasrohre mit einer Linie von Gasaustrittsöffnungen) zwischen je zwei Magnetron-Fronten angeordnet und das Gas wird hauptsächlich entlang der Länge der äussersten Magnetron-Elektroden in tangentialer Richtung und an den Stirnseiten der Trommel in axialer Richtung abgesaugt. Es ist auch möglich, beispielsweise jeden zweiten Zwischenraum zwischen benachbarten Magentron-Fronten ohne Gaszuführungsleitung zu belassen, derart, dass das Gas auch durch diese Zwischenräume abgesaugt werden kann. Die Magentron-Elektroden sind beispielsweise vom Typus, wie er in den folgenden Figuren 4 und 5 dargestellt und im Zusammenhang mit diesen Figuren beschrieben ist.

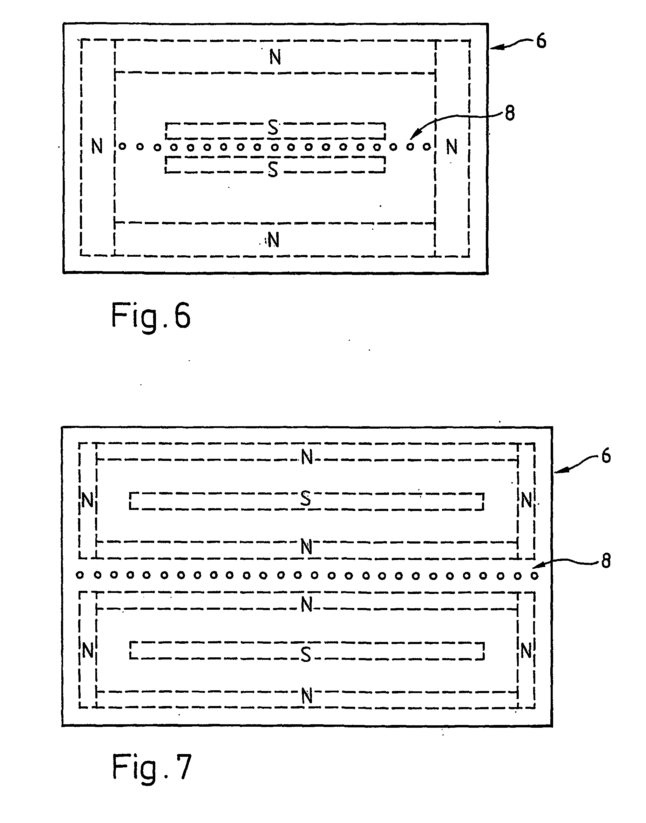

Gemäss Figur 3 sind die Magnetron-Elektroden mit Gaszuführungsleitungen ausgerüstet, die beispielsweise mittig und längs über die Magnetron-Front verlaufen. Das Gas wird zwischen benachbarten Magnetron-Fronten und in axialer Richtung abgesaugt. Wie in der Figur dargestellt, ist es auch möglich, das Plasma und das Prozessgas weiter in den Raum zwischen Magnetron-Fronten und Trommel einzuschliessen, indem seitliche Wandelemente 20 vorgesehen werden, die sich entlang der Länge jeder Magnetron-Fronten erstrecken und den Raum zwischen Magnetron-Front und Trommel derart abschliessen, dass nur für den ungehinderten Durchgang des bandförmigen Materials ein schmaler Schlitz zwischen seitlichen Wandelementen 20 und Trommel bleibt. Das Prozessgas wird in diesem Falle hauptsächlich axial abgesaugt und nur zu einem kleinen Teil durch die genannten seitlichen Schlitze. Die Magnetron-Elektroden sind beispielsweise vom Typus, wie er in den Figuren 6 oder 7 dargestellt und im Zusammenhang mit diesen Figuren beschrieben ist.

Die Anordnung gemäss Figur 3 ist geeignet entweder für die Durchführung eines spezifischen Plasma-unterstützten Prozesses oder, insbesondere wenn sie die seitlichen Wandelemente 20 aufweist, für eine Anzahl von aufeinanderfolgenden, verschiedenen Plasma-unterstützten Prozessen, in denen verschiedene Prozessgase oder Prozessgasmischungen zur Anwendung kommen. Solche aufeinanderfolgende Prozesse sind beispielsweise ein vorgängiger Reinigungs- oder Ätzschritt, ein darauf folgender Beschichtungsschritt und ein abschliessender Schritt, in dem der Beschichtungsoberfläche eine gewünschte Benetzbarkeit gegeben wird.

Typische Betriebsparameter für eine Vorrichtung gemäss Figuren 2 oder 3 sind beispielsweise: elektrische Leistung: ca. 10-20 kW per m² Magnetron-Frontfläche; Frequenz: 40 kHz oder 13,56 MHz; totale Länge des Behandlungsweges für das bandförmige Material durch das Plasma: 0,5 bis 1 m; Geschwindigkeit des bandförmigen Materials: 0,5-20 m/s. Für eine Beschichtung des bandförmigen Materials mit Siliziumoxyd für die Verbesserung der Barriereeigenschaften beträgt die Behandlungszeit wenige Sekunden; die Prozessgasmischung enthält eine Organosilizium-Verbindung und Sauerstoff und der Druck wird im Bereich einiger weniger Pa konstant gehalten.

**Figuren 4 und 5** zeigen die Front (Figur 4) und einen Schnitt senkrecht zur Front (Figur 5) einer beispielhaften Ausführungsform einer Magnetron-Elektrode, die in der erfindungsgemässen Vorrichtung anwendbar ist, insbesondere in einer Vorrichtung, wie sie in der Figur 2 dargestellt ist.

Die Magnetron-Front weist eine Anordnung von permanent magnetischen Polen auf mit einem zentralen Pol 30 und einem peripheren Pol 31, der um den zentralen Pol 30 angeordnet ist und eine entgegengesetzte Polarität aufweist. Die magnetischen Pole sind beispielsweise die Pole von stabförmigen Permanentmagneten 32, deren Pole auf zwei einander gegenüberliegenden Längsseiten angeordnet sind. Die Pole der Permanentmagnete, die von der Magnetron-Front abgewandt sind, sind untereinander durch ein magnetisches Element 33, beispielsweise aus Weicheisen, verbunden. Die Magnetron-Front ist bedeckt durch ein nicht magnetisches Elektrodenelement 34, beispielsweise aus rostfreiem Stahl, Aluminium oder Kupfer. Das Elektrodenelement ist an eine Spannungsquelle 7 angeschlossen. Vorteilhafterweise ist das Elektrodenelement 34 für eine Kühlung ausgerüstet; es weist also beispielsweise Kanäle 35 auf, die an ein Mittel zum Zirkulieren eines Kühlmediums angeschlossen sind. Wie ebenfalls in der Figur 2 gezeigt ist, sind Gaszuführungsleitungen 8 entlang der Längskanten der Magnetron-Front angeordnet. Die Gaszuführungsleitungen sind beispielsweise Rohre mit Reihen von Gasaustrittsöffnungen oder Düsen, die ausgerüstet sind für eine Gaszuführung in einer Richtung im wesentlichen senkrecht zur Magnetron-Front (Ausführung 8, wie auf der linken Seite der Magnetron-Elektrode der Figur 5 gezeigt) oder in einer Richtung im wesentlichen parallel zur Magnetron-Front (Ausführung 8', wie auf der rechten Seite der Magnetron-Elektrode gemäss Figur 5 gezeigt).

Wie bereits weiter oben diskutiert, sind die Magnetron-Elektroden 6 vorteilhafterweise auf Schienen 36 montiert, derart, dass sie für Reinigung oder Ersatz einfach von ihrer Betriebsposition entfernt und in dieser wieder positioniert werden können.

Die zentralen und peripheren Magnetpole 30 und 31, die die Magnetron-Front bilden, sind vorteilhafterweise derart dimensioniert, dass der zentrale Pol eine Magnetstärke aufweist, die von der Magnetstärke des peripheren Pols verschieden ist, das heisst, dass das Magnetron unausgeglichen (unbalanced) ist. Das bedeutet, dass nicht alle Feldlinien sich von Nord- zu Südpol der Magnetron-Front erstrecken und ein Tunnel 37 über dem Zwischenraum zwischen den Polen bilden und dass aus diesem Grunde nicht alle Elektronen zwischen den Polen zirkulierend eingeschlossen sind sondern sich teilweise ausserhalb des Tunnels befinden. Ein für eine Plasma-unterstützte, chemische Abscheidung aus der Gasphase geeigneter Magnetron-Effekt wird beispielsweise erzielt unter Verwendung der gleichen, oben genannten stabförmigen Permanentmagnete für den zentralen und den peripheren Pol. Daraus resultiert eine magnetische Stärke des zentralen Pols, die etwa halb so gross ist wie die magnetische Stärke des peripheren Pols.

Experimente zeigen, dass es insbesondere für einen Beschichtungsprozess vorteilhaft ist, die zu beschichtende Oberfläche gerade ausserhalb des Tunnels 37 zu positionieren, vorteilhafterweise in einem Abstand d von der Magnetron-Front, der zwischen etwa 2 und 20% grösser ist als die Höhe des Tunnels 37 über der Magnetron-Front. Der Tunnel 37 ist klar erkennbar als dunklerer Bereich im Plasmaraum. Die zu beschichtende Oberfläche wird nahe an der Oberseite des Tunnels positioniert aber derart, dass sich zwischen dem dunkleren Bereich des Tunnels 37 und der zu beschichtenden Oberfläche ein sichtbarer, heller Plasmastreifen erstreckt, der gegen die zu beschichtende Oberfläche eine homogene Helligkeit aufweist, das heisst eine Helligkeit, die dieselbe ist über den Tunnels und über den Zwischenräumen zwischen den Tunnels.

**Figuren 6 und 7** zeigen beispielhafte Magnetron-Fronten, die beispielsweise in der erfindungsgemässen Vorrichtung, wie sie in der Figur 3 dargestellt ist, anwendbar sind. Beide Magnetron-Elektroden, die in den Figuren 6 und 7 dargestellt sind, weisen integrale Gaszuführungsleitungen 8 auf, die parallel zur Länge mittig durch die Magnetron-Front laufen. Figur 6 zeigt eine einfache Magnetron-Front, auf der die Gaszuführungsleitung zwischen zwei Hälften des zentrale Magnetpols verläuft, Figur 7 eine Doppelmagnetron-Front mit je einem Rundtrack zwischen zentralem und peripherem Magnetpol auf jeder Seite der Gaszuführungsleitung 8.

## Patentansprüche

1. Vorrichtung zur Behandlung eines bandförmigen Materials in einem Plasma-unterstützten Prozess, welche Vorrichtung eine Vakuumkammer (1) und in der Vakuumkammer angeordnet ein Mittel für Stützung und Transport des bandförmigen Materials, ein Magnetron-Mittel und ein Gaszuführungsmittel aufweist, wobei die Vakuumkammer (1) Mittel zur Aufrechterhaltung eines konstanten reduzierten Drucks in der Vakuumkammer aufweist, wobei das Magnetron-Mittel gegen das vom Mittel für Stützung und Transport gestützte und transportierte, bandförmige Material ausgerichtet ist und wobei das Gaszuführungsmittel für eine Gaszuführung in den Raum (10) zwischen dem Mittel für Stützung und Transport und dem Magnetron-Mittel ausgerüstet ist, wobei das Magnetron-Mittel eine Mehrzahl von unabhängigen Magnetron-Elektroden (6) mit rechteckigen Magnetron-Fronten aufweist, die Magnetron-Fronten nebeinander und mit parallelen Längen von dem Mittel für Stützung und Transport beabstandet angeordnet sind, und das Mittel für Stützung und Transport elektrisch geerdet, an keine definierte Referenzspannung angeschlossen oder an eine negative Vorspannung angeschlossen ist, **gekennzeichnet dadurch, dass** jede Magnetron-Elektrode (6) durch eine eigene Spannungsquelle (7) mit einer Wechselspannung versorgt ist.

2. Vorrichtung nach Anspruch 1, **dadurch gekennzeichnet, dass** das Mittel für Stützung und Transport eine rotierende Trommel (3) ist und dass die Magnetron-Fronten mit ihrer Länge parallel zur Trommelachse und ihrer Breite im wesentlichen tangential zur Trommelfläche angeordnet sind.

3. Vorrichtung nach einem der Ansprüche 1 oder 2, **dadurch gekennzeichnet, dass** das Gaszuführungsmittel Gaszuführungleitungen (8, 8') aufweist, die sich zwischen benachbarten Magnetron-Fronten erstrecken.

4. Vorrichtung nach einem der Ansprüche 1 oder 2, **dadurch gekennzeichnet, dass** das Gaszuführungsmittel Gaszuführungsleitungen (8, 8') aufweist, die sich in den Magnetron-Fronten und parallel zu deren Länge erstrecken.

5. Vorrichtung nach einem der Ansprüche 3 oder 4, **dadurch gekennzeichnet, dass** die Gaszuführungsleitungen (8, 8') Reihen von Gasaustrittsöffnungen aufweisen, die für einen Gasaustritt im wesentlichen senkrecht oder im wesentlichen parallel zu den Magnetron-Fronten ausgelegt sind.

6. Vorrichtung nach einem der Ansprüche 4 oder 5, **dadurch gekennzeichnet, dass** Wandelemente (20) vorgesehen sind, die sich entlang der Längskanten der Magentron-Fronten erstrecken und gegen das Mittel für Stützung und Transport gerichtet sind.

7. Vorrichtung nach einem der Ansprüche 4 bis 6, **dadurch gekennzeichnet, dass** die Magnetron-Elektrode (6) ein Doppelmagnetron darstellt.

8. Vorrichtung nach einem der Ansprüche 1 bis 7, **dadurch gekennzeichnet, dass** die Anordnung von Magnetron-Elektroden und Mittel für Stützung und Transport eine Absaugung des Gases, das in den Raum (10) zwischen Magnetron-Fronten und Mittel für Stützung und Transport zugeführt wird, in axialer Richtung und/oder zwischen benachbarten Magnetron-Fronten hindurch erlaubt.

9. Vorrichtung nach einem der Ansprüche 1 bis 8, **dadurch gekennzeichnet, dass** auf den Magnetron-Fronten Elektrodenelemente (34) aus einem nicht magnetischen Material angeordnet sind, die die Magnetpole der Magnetron-Front überdecken.

10. Vorrichtung nach Anspruch 9, **dadurch gekennzeichnet, dass** die Elektrodenelemente (34) der Magnetron-Fronten Kanäle (35) aufweisen, die mit einem Mittel zur Zirkulation eines Kühlmediums durch die Kanäle (35) verbunden sind.

11. Vorrichtung nach einem der Ansprüche 1 bis 10, **dadurch gekennzeichnet, dass** die Magnetron-Elektroden vom unausgeglichenen Typus sind.

12. Vorrichtung nach Anspruch 11, **dadurch gekennzeichnet, dass** die Magnetron-Fronten einen permanentmagnetischen, zentralen und peripheren Pol (30 und 31) aufweisen, wobei der zentrale Pol (30) etwa die Hälfte der Magnetstärke des peripheren Pols (31) hat.

## Claims

1. Device for treating a web material in a plasma enhanced process, the device comprising a vacuum chamber (1) with means (2) for maintaining a constant reduced pressure within the chamber (1) and, arranged within the chamber (1), a web supporting and transporting means, a magnetron means facing the web (4) supported and transported by the supporting and transporting means and a gas supply means for supplying a process gas or process gas mixture to a space (10) between the supporting and transporting means and the magnetron means, wherein the magnetron means comprises a plurality of independent magnetron electrodes (6) with rectangular magnetron faces, the magnetron faces being arranged beside each other, with parallel lengths and at a distance from the supporting and transporting means, and the supporting and transporting means is electrically grounded, electrically floating or negatively biased, **characterized in that** each magnetron electrode (6) is powered with an alternating voltage by its own power supply means (7).

2. Device according to claim 1, **characterized in that** the supporting and transporting means is a rotating drum (3) and that the magnetron faces are arranged with their length parallel to the drum axis and their width substantially tangentially to the circumferential surface of the drum.

3. Device according to one of claims 1 or 2 **characterized in that** the gas supply means comprises gas supply lines (8, 8') extending between neighbouring magnetron faces.

4. Device according to one of claims 1 or 2, **characterized in that** the gas supply means comprises gas supply lines (8, 8') extending within the magnetron face and parallel to the length of the magnetron face.

5. Device according to claim 3 or 4, **characterized in that** the supply lines (8, 8') comprise rows of gas outlets arranged for gas injection substantially perpendicular or substantially parallel to the magnetron faces.

6. Device according to claim 4 or 5, **characterized in that** wall elements (20) extending along the longitudinal edges of the magnetron faces and towards the supporting and transporting means are provided.

7. Device according to one of claims 4 to 6, **characterized in that** the magnetron electrode (6) constitutes a twin magnetron.

8. Device according to one of claims 1 to 7, **characterized in that** the gas supplied to the space (10) between magnetron faces and the supporting and transporting means is allowed to be removed in axial direction and/or between neighbouring magnetron faces.

9. Device according to one of claims 1 to 8, **characterized in that** the magnetron faces comprise electrode pieces (34) of a non magnetic material extending over the magnetic poles constituting the magnetron face.

10. Device according to claim 9, **characterized in that** the electrode pieces (34) of the magnetron faces comprise channels (35) being connected to a means for circulating a cooling medium through the channels (35).

11. Device according to one of claims 1 to 10, **characterized in that** the magnetron electrodes (6) constitute magnetrons of an unbalanced type.

12. Device according to claim 11, **characterized in that** the magnetron faces comprise permanent magnetic central and peripheral poles (30 and 31), the central pole (30) having about half the magnetic strength of the peripheral pole (31).

## Revendications

1. Dispositif pour le traitement d'une matière sous forme de bande par un processus assisté plasma, ledit dispositif présentant une chambre à vide (1) et, disposé dans la chambre à vide, un élément de soutien et de transport de la matière sous forme de bande, un élément magnétron et un élément conducteur de gaz, la chambre à vide (1) comportant des moyens pour le maintien d'une pression réduite constante dans la chambre à vide, l'élément magnétron étant dirigé contre la matière sous forme de bande soutenue et transportée par l'élément de soutien et de transport, et l'élément conducteur de gaz étant équipé pour une conduction de gaz dans l'espace (10) entre l'élément de soutien et de transport et l'élément magnétron, ledit élément magnétron comportant une pluralité d'électrodes de magnétron (6) indépendantes à façades de magnétron rectangulaires, lesdites façades de magnétron étant disposées côte à côte et espacées de l'élément de soutien et de transport avec des longueurs parallèles, et l'élément de soutien et de transport étant électriquement mis à la terre, n'étant raccordé à aucune tension de référence définie ou étant raccordé à une tension de polarisation négative, **caractérisé en ce que** chaque électrode de magnétron (6) est alimentée en tension alternative par une source de tension (7) propre.

2. Dispositif selon la revendication 1, **caractérisé en ce que** l'élément de soutien et de transport est un tambour rotatif (3) et **en ce que** les façades de magnétron sont disposées parallèlement à l'axe du tambour suivant leur longueur et essentiellement tangentiellement à la surface de tambour suivant leur largeur.

3. Dispositif selon l'une des revendications 1 ou 2, **caractérisé en ce que** l'élément conducteur de gaz présente des conduites d'amenée de gaz (8, 8') s'étendant entre des façades de magnétron voisines.

4. Dispositif selon l'une des revendications 1 ou 2, **caractérisé en ce que** l'élément conducteur de gaz présente des conduites d'amenée de gaz (8, 8') s'étendant dans les façades de magnétron et parallèlement à leur longueur.

5. Dispositif selon l'une des revendications 3 ou 4, **caractérisé en ce que** les conduites d'amenée de gaz (8, 8') présentent des rangées d'orifices de sortie de gaz conçues pour une sortie de gaz essentiellement perpendiculaire ou essentiellement parallèle aux façades de magnétron.

6. Dispositif selon l'une des revendications 4 ou 5, **caractérisé en ce que** des éléments de paroi (20) sont prévus, s'étendant le long des bords longitudinaux des façades de magnétron et dirigés contre l'élément de soutien et de transport.

7. Dispositif selon l'une des revendications 4 à 6, **caractérisé en ce que** l'électrode de magnétron (6) constitue un double magnétron.

8. Dispositif selon l'une des revendications 1 à 7, **caractérisé en ce que** la disposition des électrodes de magnétron et de l'élément de soutien et de transport permet une aspiration du gaz conduit dans l'espace (10) entre les façades de magnétron et l'élément de soutien et de transport, en direction axiale et/ou entre des façades de magnétron voisines.

9. Dispositif selon l'une des revendications 1 à 8, **caractérisé en ce que** des éléments d'électrode (34) en matériau non magnétique sont disposés sur les façades de magnétron, lesquels recouvrent les pôles magnétiques de la façade de magnétron.

10. Dispositif selon la revendication 9, **caractérisé en ce que** les éléments d'électrode (34) des façades de magnétron comprennent des canaux (35) reliés à un élément de circulation d'un milieu réfrigérant au travers des canaux (35).

11. Dispositif selon l'une des revendications 1 à 10, **caractérisé en ce que** les électrodes de magnétron sont de type non compensé.

12. Dispositif selon la revendication 11, **caractérisé en ce que** les façades de magnétron comportent un pôle (30 et 31) magnétique permanent, central et périphérique, le pôle central (30) ayant à peu près la moitié de la force magnétique du pôle périphérique (31).
